# FASCICULE DE BREVET EUROPEEN

(11) **EP 0 599 174 B1**
(45) Date de publication et mention de la délivrance du brevet: **14.05.1997**
(21) Numéro de dépôt: 93118441.0
(22) Date de dépôt: 15.11.1993
(51) Int. Cl.: G01P 15/08, G01P 15/125

(54) **Cellule de mesure micro-usinée**
Mikromechanisch hergestellter Messaufnehmer
Micro-machined sensor

(30) Priorité: 23.11.1992 FR 9214148
(43) Date de publication de la demande: 01.06.1994
(73) Titulaire: CSEM, Centre Suisse d'Electronique et de Microtechnique S.A., CH-2007 Neuchâtel (CH)
(72) Inventeur: Hermann, Jean, CH-2000 Neuchâtel (CH)
(74) Mandataire: de Montmollin, Henri

(56) Documents cités:
- FR-A- 2 622 975
- US-A- 4 732 647

## Description

La présente invention concerne une cellule de mesure micro-usinée destinée à être montée sur un support et comportant un capteur de mesure comprenant un élément conducteur d'électricité.

On connaît déjà des cellules de mesure du type susmentionné. On connaît en particulier des cellules de mesure de ce type qui sont des cellules de mesure d'une accélération. Ces cellules, dites accélérométriques, sont constituée par un capteur de mesure capacitif comprenant une plaque de silicium dans laquelle est ménagée une électrode mobile, cette plaque étant interposée entre deux autres plaques de même réalisée en silicium, les trois plaques étant légèrement espacées les unes des autres, et l'espace entre ces plaques étant rempli par un matériau de soudage électriquement isolant, sauf au niveau de l'électrode mobile.

Une telle cellule présente des inconvénients. En effet, les cellules de ce type sont fabriquées par lots, ce qui implique qu'en fin de procédé, les cellules individuelles sont séparées les unes des autres en faisant appel à des opérations de découpage qui sont, le plus souvent, des opérations mécaniques. Or ce découpage mécanique engendre des contraintes ou même cause des fissures ou court-circuits au niveau de la partie active de la cellule.

En outre, dans la pratique, une cellule de mesure est le plus souvent montée dans le boîtier d'un dispositif électronique auquel elle est associée électriquement, le montage étant réalisé par un simple collage d'une face de la cellule sur une surface plane du boîtier. La présence de colle sur une face de la cellule micro-usinée produit des contraintes qui peuvent se propager jusqu'à la partie active de la cellule formant le capteur de mesure proprement dit. Ces contraintes dépendent notamment de la température et provoquent l'apparition d'un effet d'hystérèse thermique influençant aussi bien la sensibilité du dispositif que le décalage de la position du zéro indiqué par celui-ci (offset). De plus on voit apparaître un effet de viellissement qui s'ajoute à cet effet d'hystérèse.

La présente invention a donc pour but de pallier les inconvénients qui viennent d'être décrits en fournissant une cellule de mesure dans laquelle les contraintes mécaniques provoquées, notamment lors du découpage ou du collage de la cellule sur son support, ne peuvent pas se propager jusqu'au capteur de mesure proprement dit et n'influencent donc pas la mesure.

Ainsi, l'invention a pour objet une cellule de mesure micro-usinée destinée à être montée sur un support et comportant une capteur comprenant un élément conducteur d'électricité, caractérisée en ce qu'elle comporte une structure de montage distincte dudit capteur et reliée à ce dernier par au moins un bras de liaison destiné à supporter le dit capteur, au moins un élément de la structure de montage, un élément du bras de liaison et un élément du capteur étant en outre réalisés ensemble en une seule pièce.

Grâce à ces caractéristiques on peut, lors de l'opération de fixation de la cellule sur son support, limiter l'application de la colle à des surfaces faisant partie de la structure de montage uniquement, et donc laisser libres les parois du capteur proprement dit. En réalisant ainsi le collage de la cellule de mesure au niveau de la stucture de montage, on confine l'essentiel des contraintes mécaniques au niveau de cette structure. En effet, grâce à cette configuration, la transmission des contraintes mécaniques depuis la structure de montage vers le capteur ne peut se faire que par l'intermédiaire du bras de liaison qui a une section relativement faible, et constitue ainsi une zone d'evanescence des contraintes, à travers laquelle les contraintes mécaniques ne sont transmises que dans une proportion extrêmement réduite.

Le fait que la cellule de mesure conforme à la présente invention comporte une structure de montage distincte du capteur proprement dit présente aussi l'avantage de faciliter la manipulation de la cellule, lors de sa mise en place sur son support. En effet, la cellule peut être saisie, par un bras manipulateur par exemple, au niveau de la structure de montage, ce qui évite tous risques d'endommagement du capteur.

Mais d'autres caractéristiques et avantages de l'invention apparaîtront à la lecture de la description détaillée qui suit donnée à titre d'exemple et prise en référence aux figures annexées, représentant un mode particulier de réalisation de l'invention, et dans lesquelles :
- la figure 1 est une vue en perspective partiellement arrachée d'une cellule accélérométrique de l'art antérieur,
- la figure 2 est une vue en perspective partiellement arrachée d'un mode particulier de réalisation d'une cellule de mesure accélérométrique conforme à la présente invention,
- la figure 3 est une vue de dessus de la cellule accélérométrique de la figure 2 dont on a retiré la plaque de couverture,

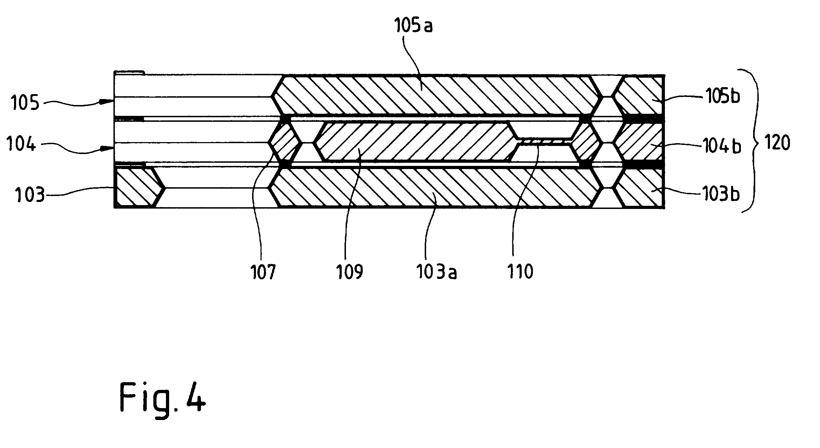

- la figure 4 est une vue en coupe de la cellule accélérométrique de la figure 2, faite selon la ligne IV-IV de cette figure,
- les figure 5a, 5b et 5c sont des vues partielles, de dessus, de plaquettes de silicium sur lesquelles ont été gravées respectivement des premières, secondes et troisièmes plaques de cellules accélérométriques conformes à celle représentée sur la figure 2.

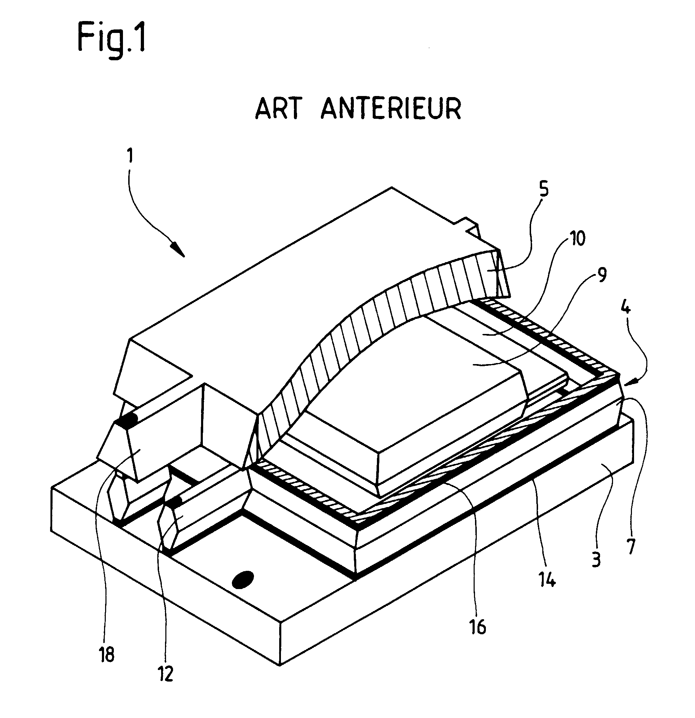

Comme on le voit sur la figure 1, une cellule accélérométrique 1 de l'art antérieur est constituée d'une première, d'une deuxième et d'une troisième plaque superposées et référencées respectivement 3, 4 et 5 et réalisées chacune en une seule pièce à partir d'un matériau micro-usinable et conducteur d'électricité, par exemple du silicium. La première plaque 3 constitue une base rectangulaire pour la cellule accélérométrique et elle reçoit sur sa face supérieure la deuxième plaque 4. Une couche d'oxyde 14 disposée entre les deux plaques 3 et 4 assure le collage de ces dernières l'une sur l'autre et simultanément les isole électriquement l'une de l'autre. La deuxième plaque 4 comporte une partie intérieure constituant une électrode mobile 9. Cette électrode 9 est solidaire par un de ses côtés du reste de la plaque qui forme un cadre 7 entourant l'électrode mobile 9. La mobilité de l'électrode 9 par rapport au cadre 7 est assurée par le fléchissement d'une région amincie 10 qui relie l'électrode 9 au cadre 7.

La deuxième plaque 4 reçoit à son tour, sur sa face supérieure, la troisième plaque 5, et le collage de ces deux plaques l'une sur l'autre est réalisé par une deuxième couche d'oxyde isolant 16.

Les couches d'oxyde 14 et 16 remplissent ainsi deux espaces résiduels entre les plaques 3, 4 et 5, mais comme on le voit sur la figure 1, ces couches ne s'étendent pas à l'intérieur de l'enceinte du cadre 7, c'est-à-dire dans la région de l'électrode mobile 9, si bien que cette dernière est laissée libre de se déplacer. On voit encore sur la figure 1 que la deuxième et la troisième plaque 4 et 5 comprennent chacune une barre de connexion électrique, portant la référence 12 et 18, respectivement.

La première plaque 3, le cadre 7 formant la partie extérieure de la deuxième plaque 4, et la troisième plaque 5 constituent ainsi une enceinte hermétique à l'intérieur de laquelle l'électrode mobile 9 peut se déplacer. Les deux couches d'oxyde 14 et 16 isolent électriquement les trois plaques les unes des autres, et celles-ci forment ensemble un capteur capacitif dont le principe général de fonctionnement est bien connu. Notons en particulier que la première et la troisième plaque 3, 5 constituent les deux électrodes fixes du capteur entre lesquelles se déplace l'électrode mobile 9. La liaison électrique entre un dispositif électronique, non représenté, et les trois plaques 3, 4, 5 formant les trois électrodes de cette cellule accélérométrique, sont assurées par trois conducteurs soudés sur trois zones de métalisation situées respectivement sur les barres de connexion 18 et 12 et sur une partie exposée de la première plaque 3.

De telles cellules accélérométriques sont généralement réalisées par micro-usinage à partir de plaquettes ou "wafers" en silicium. Chacune des plaques 3,4 et 5 de la cellule accélérométrique est obtenue à de multiples exemplaires à partir d'un "wafer". Un tel "wafer" a le plus souvent la forme d'une pastille de silicium de 100 mm de diamètre et 0,4 mm d'épaisseur.

Pour fabriquer des cellules accélérométriques on reproduit, tout d'abord, à de multiples exemplaires, respectivement sur trois "wafers", le relief correspondant aux trois plaques 3,4 et 5 de l'accéléromètre, à l'aide de techniques de micro-usinage appropriées. Des couches d'oxyde isolant sont ensuite disposées sur des zones déterminées de la surface des trois "wafers" pour permettre le collage subséquent de ceux-ci les uns sur les autres. Le collage est effectué à haute température par fusion des couches d'oxyde. L'assemblage ainsi réalisé est finalement découpé par sciage d'environ 200 cellules accélérométriques semblables à celle qui a été décrite plus haut.

Un des problèmes rencontré avec de telle réalisation est lié à l'opération de sciage. En effet, cette opération est assez brutale et peut produire des bavures sur la tranche des plaques de silicium découpées des "wafers" respectifs. Ces plaques à l'état assemblé n'étant séparées que par une très faible épaisseur d'oxyde isolant comme on l'a décrit en rapport avec la figure 1, la présence de bavures sur les arêtes des plaques peut occasionner des court-circuits entre celles-ci. L'opération de sciage peut en outre produire des contraintes locales responsables de phénomènes d'hystérèse thermique.

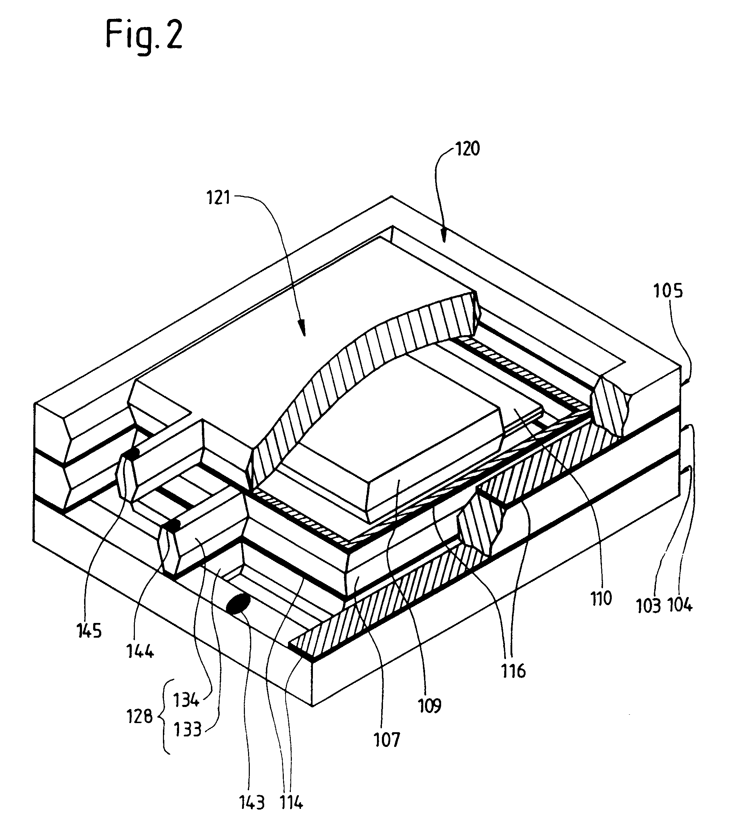

En se référant maintenant aux figures 2 et suivantes qui décrivent un mode particulier de réalisation d'une cellule accélérométrique selon la présente invention, on voit que la cellule accélérométrique représentée comporte une structure de fixation 120 qui a la forme d'un cadre entourant complètement le capteur accélérométrique proprement dit, référencé 121.

Le capteur capacitif 121 a dans le présent mode de réalisation, une structure et un fonctionnement très semblables à ceux du capteur capacitif de l'art antérieur. Toutefois, au lieu d'être destiné à être monté directement sur un support, comme le capteur représenté sur la figure 1, le présent capteur est, conformément à l'invention, relié par un bras de liaison 128 à la structure de montage 120. Le bras de liaison 128 est comme on peut le voir sur la figure 2, formé par deux barres 133 et 134 qui sont collées l'une à l'autre par une couche d'oxyde isolant 114. La structure de montage 120 a la forme d'un cadre qui entoure complètement le capteur capacitif 121. Ce cadre comporte sur un de ses côtés une ouverture qui permet l'accès à trois zones de métalisation 143, 144 et 145 réalisées sur la surface du silicium et destinées à recevoir trois connexions électriques pour respectivement les trois électrodes du capteur capacitif 121.

De façon semblable à ce qui a été décrit plus haut en relation avec l'art antérieur, on fabrique un lot ou "batch" de cellules accélérométriques identiques à celle qui est représentée sur la figure 2, par sciage à partir d'un assemblage de trois "wafers" en silicium collés les uns aux autres par des couches d'oxyde électriquement isolantes, et dans l'épaisseur desquelles on a sculpté respectivement par micro-usinage la forme des trois plaques dont est formée la cellule.

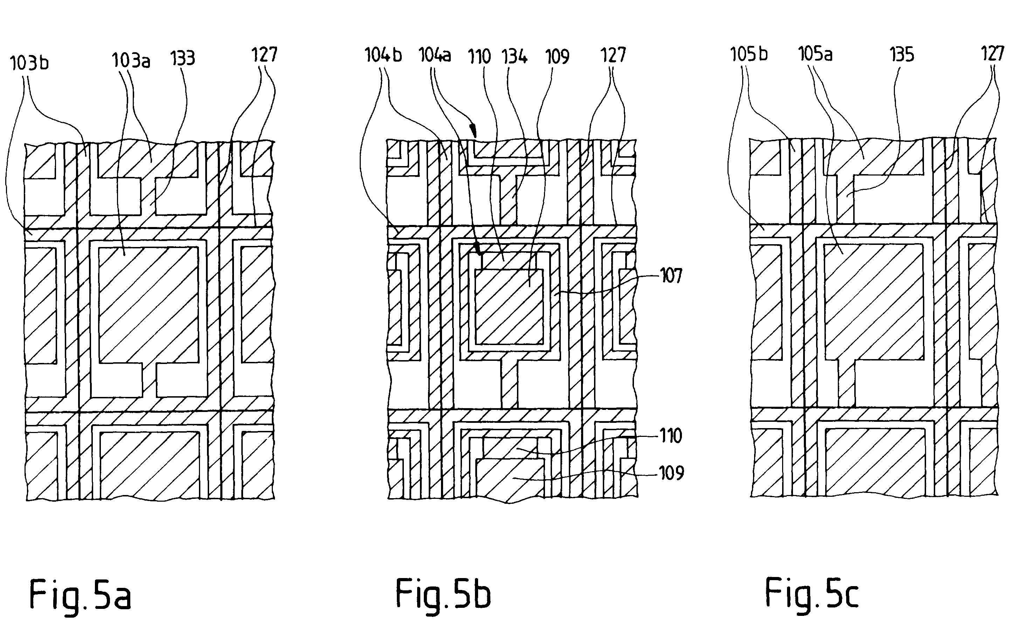

On va maintenant décrire en détail les constituants de la cellule accélérométrique et le procédé de réalisation de celle-ci, en se référant plus particulièrement aux figures 5a, 5b et 5c. Ces figures sont des vues partielles de trois "wafers" sur lesquels ont été respectivement gravés à de multiples exemplaires les reliefs des trois plaques 103,104 et 105 constituant la cellule accélérométrique. Comme on peut le voir sur ces figures, chacune des trois plaques a été gravée à de multiples exemplaires dans l'épaisseur d'un des trois "wafers" par érosion chimique pour produire un motif périodique. A la fin de cette opération de micro-usinage, chacun des "wafers" présente l'aspect d'une structure en forme de grille dont les bareaux sont constitués par des éléments en forme de cadre référencés respectivement 103b, 104b et 105b. Des éléments intérieurs référencés respectivement 103a, 104a et 105a sur les figure 5a, 5b et 5c sont conformés à l'intérieur de chacun des maillons de la structure en forme de grille. Ces éléments intérieurs sont distincts des éléments en forme de cadre et reliés à ceux-ci par des barres de liaison référencées respectivement 133, 134 et 135. On voit encore sur les figures 5a à 5c des traits mixtes référencé 127 qui se coupent à angle droit. Ces traits mixtes n'ont pas de réalité physique à ce stade du procédé de fabrication, mais ils indiquent les lignes selon lesquelles l'assemblage formé par les trois "wafers" juxtaposés sera ultérieurement scié pour, à la fin du procédé de fabrication, séparer les cellules accélérométriques les unes des autres. Les traits mixtes déterminent donc sur les figures 5a à 5c des rectangles qui contiennent chacun les constituants d'une cellule accélérométrique donnée.

Les éléments 103a,104a et 105a formeront, une fois les trois "wafers" collés les uns aux autres et sciés, le capteur capacitif 121 alors que les éléments en forme de cadre 103b, 104b et 105b formeront la structure de montage 120 aussi en forme de cadre. Les éléments 103a et 105a sont les électrodes fixes du capteur capacitif, alors que l'élément 104a est formé d'un cadre 107 à l'intérieur duquel est disposée une électrode mobile 109 reliée au cadre 107 par une partie mince et donc flexible 110.

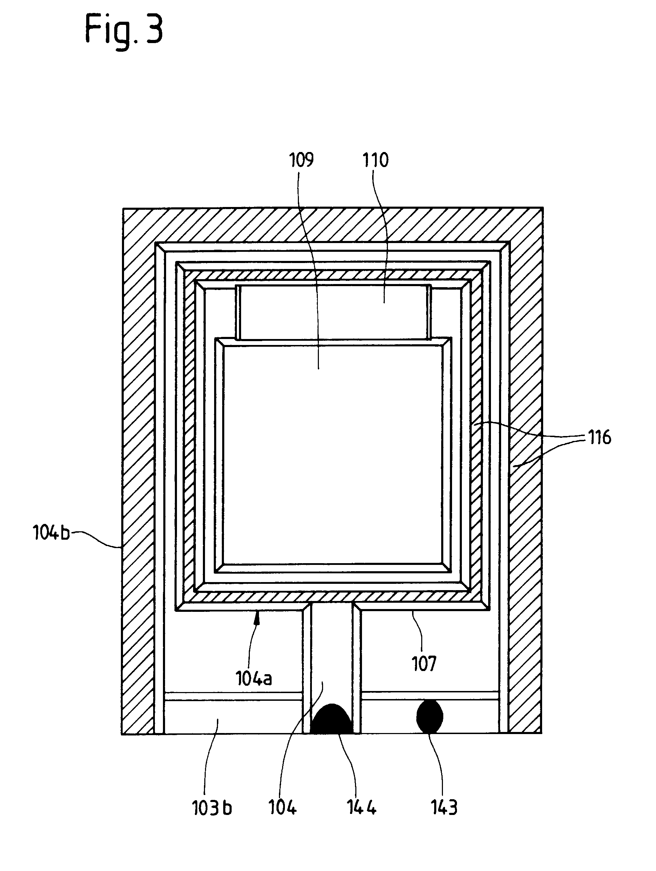

Pour, d'une part, permettre le collage des "wafers" les uns sur les autres et, d'autre part, assurer l'isolation électrique entre les électrodes du capteur capacitif, des zones d'oxyde isolant (non représentées sur les figures 5) sont créées sur les surfaces de silicium. La couche d'oxyde 116 séparant les plaques 104 et 105 de la cellule accélérométrique est visible sur la figure 3 qui représente une cellule accélérométrique dont on a retiré la troisième plaque (référencée par 105 sur les autres figures).

On remarquera sur les figures 5a, 5b et 5c que les traits mixtes 127 sont toujours tracés sur des portions des "wafers" faisant parties de la structure en forme de grille qui est constituée par les éléments 103b, 104b et 105b constitutifs de la structure de montage, et que notamment ces traits mixtes ne coupent jamais les éléments intérieurs 103a, 104a et 105a constitutifs du capteur capacitif 121. Grâce à cette caractéristique, l'opération de sciage ne risque pas de provoquer les problèmes énumérés plus haut en relation avec l'art antérieur. On remarquera de plus, que sur la figure 5a les traits mixtes 127 ne coupent pas les barres de liaison 133 qui relient les éléments 103a aux éléments 103b. En revanche, sur les figures 5b et 5c les traits mixtes 127 coupent les barres de liaisons 134 et 135 respectivement. On comprendra donc qu'une fois l'opération de sciage effectuée le long des traits mixtes 127, les parties extérieures 104b et 105b seront complétement séparées des parties intérieures 104a et 105a respectivement, alors que la plaque 103 formée par les parties 103a et 103b conservera sa structure unitaire. Grâce à cette disposition les éléments 104b et 105b de la structure de montage en forme de cadre 120 ne seront en contact électrique ni avec la deuxième, ni avec la troisième électrode du capteur capacitif. Dans ces conditions tout risque de provoquer un court-circuit entre les plaques du capteur durant l'opération de sciage ou durant une manipulation ultérieure est éliminé.

Comme on vient de le décrire, une fois l'opération de sciage effectuée, les barres de liaison 134 et 135 ne relient plus le capteur capacitif aux éléments 104b et 105b de la structure de montage. Toutefois, la barre de liaison 134 réalise encore une fonction de renforcement de la barre de liaison 133 à laquelle elle est collée par la couche d'oxyde 114. Les barres de liaison 133 et 134 forment ainsi ensemble un bras de liaison unique 128 qui relie le capteur capacitif 121 à la structure de montage 120. Il importe en effet que ce bras de liaison, qui soutient à lui seul le capteur, soit extrêmement rigide, et ceci tout particulièrement pour un fléchissement co-linéaire avec l'accélération que l'on désire mesurer. Les barres de liaison 134 et 135 portent en outre les plages de connexion 144 et 145 prévues pour le branchement, respectivement de la deuxième et de la troisième életrode du capteur capacitif.

## Revendications

1. Cellule de mesure micro-usinée destinée à être montée sur un support et comportant un capteur (121) comprenant au moins un élément conducteur d'électricité (103a, 104a, 105a), caractérisée en ce qu'elle comporte une structure de montage (120) distincte dudit capteur (121) et reliée à ce dernier par au moins un bras de liaison (128) destiné à supporter ledit capteur, au moins un élément (103b) de la structure de montage, un élément (133) du bras de liaison et un élément (103a) du capteur étant en outre réalisés ensemble en une seule pièce.

2. Cellule de mesure selon la revendication 1, caractérisée en ce que ledit élément (103a) du capteur, ledit élément (133) du bras de liaison et ledit élément (103b) de la structure de montage sont réalisés en un matériau conducteur d'électricité.

3. Cellule de mesure selon la revendication 1 ou 2, caractérisée en ce que ledit capteur (121) est un capteur capacitif.

4. Cellule de mesure selon la revendication 3, caractérisée en ce que ledit capteur capacitif (121) comprend une première (103a), une deuxième (109) et une troisième électrode (105a), ladite deuxième électrode (109) étant interposée entre la première (103a) et la troisième électrode (105a) et mobile entre ces dernières qui sont fixes l'une par rapport à l'autre, un espace étant en outre ménagé entre lesdites électrodes pour permettre le déplacement de ladite deuxième électrode (109) sous l'effet d'une force.

5. Cellule de mesure selon la revendication 4, caractérisée en ce qu'elle est une cellule accélérométrique.

6. Cellule de mesure selon la revendication 4 ou 5, caractérisée en ce que ledit capteur capacitif (121) comprend trois plaques conductrices (103a, 104a, 105a) isolées les unes des autres, deux desdites plaques au moins (103a, 104a) comprenant chacune une partie allongée (133, 134) qui forment ensemble ledit bras de liaison (128).

7. Cellule de mesure conforme à l'une des revendications 4,5 ou 6, caractérisée en ce qu'une seule desdites trois plaques (103) est en contact électrique avec ladite structure de montage (120).

8. Cellule accélérométrique conforme à l'une des revendications précédentes, caractérisée en ce que ladite structure de montage (120) a la forme d'un cadre qui entoure au moins partiellement ledit capteur capacitif (121).

9. Cellule accélérométrique conforme à la revendication 8, caractérisée en ce que ledit cadre (120) entoure totalement ledit capteur capacitif (121) à l'exception d'une ouverture ménagée dans un des côtés du cadre (120).

## Patentansprüche

1. Mikrobearbeitete Meßzelle, die dazu bestimmt ist, auf einem Support angebracht zu werden, und die einen Sensor (121) mit mindestens einem elektrisch leitenden Element (103a, 104a, 105a) umfaßt, dadurch gekennzeichnet, daß sie eine gegenüber dem Sensor (121) gesonderte Montagestruktur (120) umfaßt und mit jenem über mindestens einen, der Abstützung des Sensors dienenden Verbindungsarm (128) verbunden ist, und daß mindestens ein Element (103b) der Montagestruktur, ein Element (133) des Verbindungsarmes und ein Element (103a) des Sensors ferner gemeinsam in einem einzigen Bauteil realisiert sind.

2. Meßzelle nach Anspruch 1, dadurch gekennzeichnet, daß das genannte Element (103a) des Sensors, das genannte Element (133) des Verbindungsarmes und das genannte Element (103b) der Montagestruktur aus einem elektrisch leitenden Material hergestellt sind.

3. Meßzelle nach Anspruch 1 oder 2, dadurch gekennzeichnet, daß der Sensor (121) ein kapazitiver Sensor ist.

4. Meßzelle nach Anspruch 3, dadurch gekennzeichnet, daß der kapazitive Sensor (121) eine erste (103a), eine zweite (109) und eine dritte Elektrode (105a) umfaßt, wobei die zweite Elektrode (109) zwischen der ersten (103a) und der dritten Elektrode (105a) eingefügt ist und zwischen diesen letzteren beweglich ist, welche zueinander festgelegt sind, und wobei ein Zwischenraum zwischen den Elektroden vorgesehen ist, um die Verlagerung der zweiten Elektrode (109) unter der Wirkung einer Kraft zu ermöglichen.

5. Meßzelle nach Anspruch 4, dadurch gekennzeichnet, daß sie eine Beschleunigungsmeßzelle ist.

6. Meßzelle nach Anspruch 4 oder 5, dadurch gekennzeichnet, daß der kapazitive Sensor (121) drei leitende Platten (103a, 104a, 105a), die gegeneinander isoliert sind, umfaßt, wobei mindestens zwei der Platten (103a, 104a) jeweils eine langgestreckte Partie (133, 134) umfassen, die gemeinsam den Verbindungsarm (128) bilden.

7. Meßzelle nach einem der Ansprüche 4, 5 oder 6, dadurch gekennzeichnet, daß nur eine der genannten drei Platten (103) in elektrischem Kontakt mit der Montagestruktur (120) ist.

8. Beschleunigungsmeßzelle nach einem der vorangehenden Ansprüche, dadurch gekennzeichnet, daß die Montagestruktur (120) die Form eines Rahmens aufweist, der mindestens teilweise den kapazitiven Sensor (121) umschließt.

9. Beschleunigungsmeßzelle nach Anspruch 8, dadurch gekennzeichnet, daß der Rahmen (120) den kapazitiven Sensor (121) vollständig mit Ausnahme einer Öffnung, eingearbeitet in eine der Seiten des Rahmens (120), umschließt.

## Claims

1. Micromachined measuring cell adapted to be mounted on a support and having a sensor (121) comprising at least one electrically conducting element (103a, 104a, 105a), characterized in that it comprises an assembly structure (120) distinct from said sensor (121) and connected to this latter by at least one connecting arm (128) adapted to support said sensor, at least one element (103b) of the assembly structure, one element (133) of the connecting arm and one element (103a) of the sensor being manufactured together as a single piece.

2. Measuring cell according to claim 1, characterized in that said element (103a) of the sensor, said element (133) of the connecting arm and said element (103b) of the assembly structure are made of an electrically conducting material.

3. Measuring cell according to claim 1 or 2, characterized in that said sensor (121) is a capacitive sensor.

4. Measuring cell according to claim 3, characterized in that said capacitive sensor (121) has a first (103a), a second (109) and a third electrode (105a), said second electrode (109) being interposed between the first (103a) and the third electrode (105a) and movable between these latter which are fixed in relation to one another, a gap being provided between said electrodes to allow the displacement of said second electrode (109) upon the effect of a force.

5. Measuring cell according to claim 4, characterized in that it is an accelerometric cell.

6. Measuring cell according to claim 4 or 5, characterized in that said capacitive sensor (121) comprises three conducting plates (103a, 104a, 105a) insulated from one another, at least two of said plates (103a, 104a) each comprising an elongated part (133, 134) which together form said connecting arm.

7. Measuring cell according to any of claims 4, 5 or 6, characterized in that a single one of said three plates (103) is in electrical contact with said assembly structure (120).

8. Accelerometric cell according to any of the preceding claims, characterized in that said assembly structure (120) has the shape of a frame which at least partially surrounds said capacitive sensor (121).

9. Accelerometric cell according to claim 8, characterized in that said frame (120) totally surrounds said capacitive sensor (121) with the exception of an opening provided in one of the sides of the frame (120).
